Europäisches Patentamt

European Patent Office

Office européen des brevets

(19)

(11) Veröffentlichungsnummer: **0 103 748**
**B1**

(12) **EUROPÄISCHE PATENTSCHRIFT**

(45) Veröffentlichungstag der Patentschrift: **25.07.90**

(21) Anmeldenummer: **83108085.8**

(22) Anmeldetag: **16.08.83**

(51) Int. Cl.⁵: **H 01 L 23/64,** H 01 L 23/15,
H 01 L 27/12

(54) Kombinierte Schaltung mit Varistor.

(30) Priorität: **20.08.82 DE 3231118**

(43) Veröffentlichungstag der Anmeldung:
**28.03.84 Patentblatt 84/13**

(45) Bekanntmachung des Hinweises auf die
Patenterteilung:
**25.07.90 Patentblatt 90/30**

(84) Benannte Vertragsstaaten:
**CH DE FR GB IT LI NL**

(56) Entgegenhaltungen:
FR-A-2 395 577
US-A-3 743 897

(73) Patentinhaber: **Siemens Aktiengesellschaft**
**Wittelsbacherplatz 2**
**D-8000 München 2 (DE)**

(72) Erfinder: **Einzinger, Richard, Dipl.-Phys.**
**Barthol.-Bacherstrasse 4**
**D-8222 Ruhpolding (DE)**

Courier Press, Leamington Spa, England.

EP 0 103 748 B1

## Beschreibung

Die vorliegende Erfindung bezieht sich auf eine kombinierte Schaltungsanordnung, wie sie im Oberbegriff des Patentanspruchs 1 angegeben ist.

Eine Schaltungsanordnung nach dem Oberbegriff ist aus der DE—OS 21 20 787 bekannt. Es handelt sich dort um eine integrierte Schaltung aus aktiven und passiven Bauelementen, bei der Schichten aus Dotierstoffen zur Erzeugung aktiver Bauelemente und leitender Kontakte sowie Schichten aus Stoffen vorliegen, die Isoliershichten auf der Oberfläche eines Halbleiter-Substratkörpers bilden. Auf einer solchen Isolierschicht können weitere Schichten aufgebracht sein, die als Leiterbahnen, Widerstände oder Kondensatoren verwendet werden können. Für die Herstellung einer solchen Schaltungsanordnung ist dort abgegeben, den Halbleiter-Substratkörper als gemeinsamen Substratkörper für die aktiven und passiven Bauelemente vorzusehen und das Aufbringen mittels Siebdruckes durchzuführen. Es ist dort auch angegeben, Gläser durch Siebdruck aufzubringen, die Durch Strom- oder Spannungsstoß in den leitenden Zustand und wieder in den Ausgangszustand versetzt werden können. Bezüglich einer solchen Glasschicht ist auch angegeben, sie als Quelle für Dotierelemente für durchzuführende Dotierungsdiffusionen zu verwenden.

Insbesondere zum Schutz gegen Überspannungen ist es bekannt, Schaltungen—vorzugsweise Halbleiterschaltungen—Überspannungshalbleiter zuzuordnen. Hierfür eignen sich besonders Varistoren, die elektrisch mit Zuleitungen jeweiliger Schaltungen verbunden werden.

Vorzugsweise sind Varistoren aus dotierter Zinkoxid-Keramik bestehende Bauelemente mit an bzw. auf dem Keramikkörper befindlichen Elektroden (US—A—3 743 897, 3 768 058 und 3 805 114). Bei niedriger anliegender Spannung hat ein Varistor hochohmiges Verhalten und erste bei höher anliegender Spannung wird er niederohmiger. Strom J und Spannung U sind bei einem solchen Bauelement der Gleichung $J=(U/K)\alpha$ entsprechend voneinander abhängig, wobei K eine Materialkonstante und $\alpha$ der Koeffizient der Nichtlinearität ist. Der Zinkoxid-Keramikkörper eines Varistors kann durch und durch die elektrische Varistoreigenschaft haben (US—A—3 743 897). Bekannt sind aber auch solche Varistoren, bei denen nur ein Schichtbereich des Zinkoxid-Keramikkörpers diese Varistoreigenshaft hat (DE—A—28 20 118, DE—A—29 21 497). Das Zinkoxid des übrigen Anteils des Keramikkörpers eines solchen Varistors ist spannungsunabhängig stets niederohmig. Außerdem ist aus US—A—3 743 897, Fig. 6 bekannt, einen dünnen Varistor als Schicht auf einem dielektrischen Substrat vorzusehen.

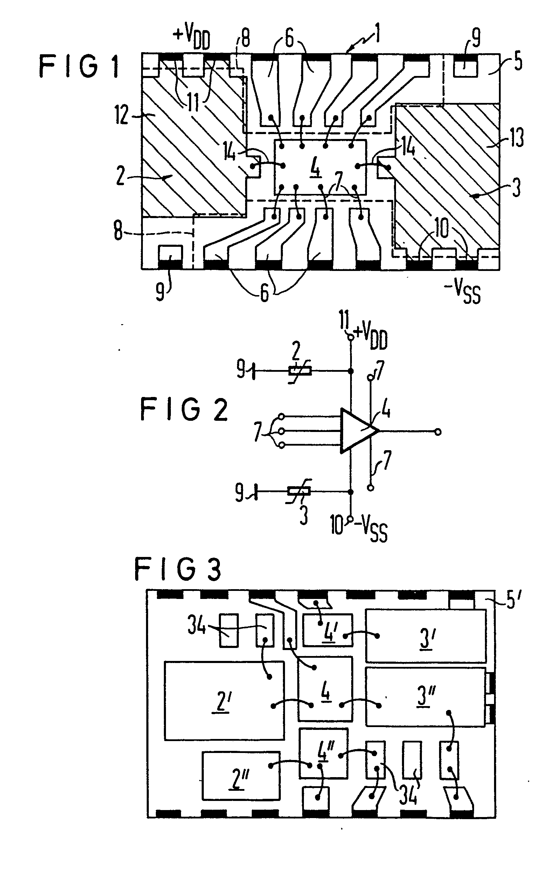

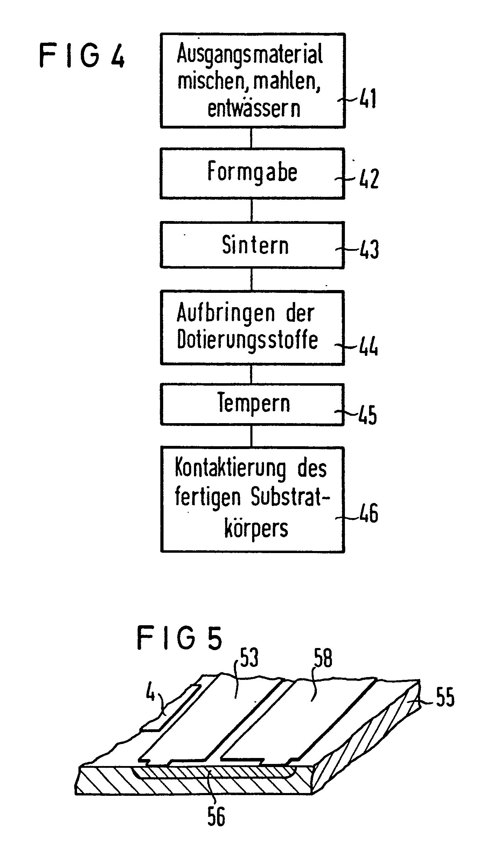

In der US—A—3 743 897, Fig. 2 und 4 sind auch Ausführungsformen beschrieben, bei denen das Substrat ein einziger Körper aus durch und durch Varistormaterial ist, der an allen Stellen zwischen allen auf der Substratoberfläche befindlichen Leiterbahnen Varistorwirkung bewirkt.

Hergestellt wird ein solcher Varistor z.B. dadurch, daß zunächst ein spannungsunabhängig niederohmiger Zinkoxid-Keramikkörper hergestellt wird, und zwar durch Mischen der Ausgangssubstanzen, Mahlen des Schlickers, Pressen zu Formkörpern und Sintern der Formkörper. Die Varistoreigenschaft wird dann nachträglich durch Eindiffusion von einem oder mehreren der Dotierungsstoffe, wie z.B. Wismutoxid, Boroxid, Kobaltoxid, Antimonoxid, Chromoxid, Titanoxid, Praseodymoxid, Kalziumoxid und anderen, erzielt.

Im Zusammenhang mit der Verwendung von Schaltungen, die z.B. reine Halbleiterschaltungen, Hybridschaltungen sind und/oder anderen Aufbau haben können, ist das Bestreben stets danach gerichtet, Überspannungsschutz mit möglichst induktivitätsarmem Aufbau bei möglichst geringem Raumbedarf zu erreichen. Induktivitätsbehafteter Aufbau des Überspannungsschutzes führt zu einer Verminderung der Schutzwirkung bei Überspannungen mit hoher Anstiegsgeschwindigkeit. Auch soll eine jeweilige neue Schaltungsanordung mit den technologischen Mitteln und Verfahren herzustellen sein, die schon bisher verwendet wurden und auf die die Produktionsbetriebe eingerichtet sind.

Es ist somit eine Aufgabe der vorliegenden Erfindung, für eine Kombination aus einer oder mehreren integrierten Schaltungen mit gegebenenfalls weiteren Bauelementen und aus einem oder mehreren Varistoren eine solche induktivitätsarme kombinierte Schaltungsanordnung anzugeben, die einerseits den Fertigungsmethoden angepaßt ist und anderer seits möglichst wenig Raum beansprucht.

Diese Aufgabe wird für eine kombinierte Schaltungsanordung nach dem Oberbegriff des Patentanspruchs 1 erfindungsgemäß mit Hilfe der Merkmale des Kennzeichens des Anspruchs 1 gelöst. Nach einem anspruchsgemäßen Verfahren können solche kombinierte Schaltungsanordnungen der Erfindung besonders vorteilhaft hergestellt werden.

Die Erfindung geht von dem Gedanken aus, daß der Varistor, der im Zusammenhang mit weiteren Bauelementen vorgesehen sein soll, ein ebenfalls in die Kombination integriertes Bauteil sein sollte. Die Überlegungen gehen dahin, den für eine kombinierte Schaltungsanordnung und insbesondere für mehrere zusammengehörige integrierte Schaltungen und weitere Bauelemente im Regelfall verwendeten Trägerkörper als Substratkörper der Gesamtkombination auszubilden und in diesem Substratkörper den oder die notwendigen Varistoren zu realisieren. Anstatt wie für voranstehend beschriebene Fälle niederohmige Zinkoxid-Keramik für einen Varistor zu verwenden, ist hier bei der Erfindung vorgesehen, für den Substratkörper eine elektrisch isolierende bzw. möglichst hochohmige Zinkoxid-Keramik zu verwenden. Tatsächlich läßt sich solche Keramik—wie noch nachfolgend dargelegt wird—herstellen.

Auf dem isolierenden Substratkörper aus Zinkoxid befinden sich eine oder mehrere integrierte Schaltung(en), gegebenenfalls weitere Bauelemente, und die zugehörigen elektrischen Leiterbahnen. Die elektrischen Verbindungen zwischen einer integrierten Schaltung und den Leiterbahnen sind vorzugsweise Drahtverbindungen, die mit üblichen Maschinen hergestellt sind. Flächenanteile des gemäß einem Merkmal der Erfindung vorgesehenen isolierenden Zinkoxid-Substratkörpers, die weder für integrierter Schaltungen noch für Leiterbahnen benötigt werden, stehen für den einen oder die mehreren Varistoren zur Verfügung.

Für den einen oder die mehreren Varistoren können sogar auch Flächen- bzw. Volumenanteile des Substratkörpers verwendet werden, auf denen sich zumindest teilweise ein oder mehrere integrierte Schaltungen und gegebenenfalls sonstige Bauelemente befinden. Dies ist z.B. dann besonders günstig, wenn sich eine solche Schaltung auf bzw. über der Masseelektrode des Varistors befindet, wobei diese Masseelektrode außerdem noch Abschirmung für die darüberliegende Schaltung bewirkt.

Das Zinkoxoxid-Material unterhalb solcher Flächenanteile ist durch Eindiffusion von wie obengenannten Dotierungsstoffen aus dem zuvor elektrisch isolierenden Zustand in den Zustand mit Varistoreigenschaft umgewandelt. Insbesondere zum Schutz gegen Überspannungen mit hoher Energie ist est vorteilhaft, unterhalb des jeweiligen Flächenanteils des Substratkörpers diesen in seiner ganzen Dicke in Varistoreigenschaft umzuwandeln. In einem solchen Falle liegt dann der Varistor zwischen einer Elektrode auf einem solchen Flächenanteil der Vorderseite des Substratkörpers und einer Gegenelektrode auf der gegenüberliegenden Rückseite dieses Substratkörpers vor.

Weitere Erläuterungen der Erfindung gehen aus der nachfolgenden, anhand der Figuren gegebenen Beschreibung zu Ausführungsbeispielen der Erfindung bevor. Dabei zeigt

Fig. 1 eine erfindugsgemäß kombinierte Schaltungsanordnung,

Fig. 2 das Schaltbild dazu,

Fig. 3 eine Übersichtsdarstellung einer erfindungsgemäßen Hybridschaltung,

Fig. 4 ein Flußdiagramm zum Herstellungsverfahren und

Fig. 5 eine weitere Ausführungsform.

Fig. 1 zeigt mit 1 bezeichnet ein Beispiel einer erfindungsgemäßen kombinierten Schaltungsanordnung mit zwei Varistoren 2 und 3 und einer integrierten Schaltung 4. Diese integrierte Schaltung 4 ist z.B. ein Halbleiterplättchen, in dem sich die elektronischen Strukturen befinden und das auf in der Fig. 1 oberen Oberfläche des Substratkörpers 5 aus elektrisch isolierender Zinkoxid-Keramik angebracht ist. Mit 6 sind Leiterbahnen bezeichnet, die bis an den jeweils benachbarten Rand des Substratkörpers 5 reichen und dort Anschlußkontakte bilden. Diese Leiterbahnen reichen bis nahe an die Schaltung 4 heren und sind jeweils mit den zugehörigen Kontakten dieser Schaltung 4 durch Drahtverbindungen 7 elektrisch verbunden.

Unterhalb dieser durch Schraffur hervorgehobenen Flächenanteile der Varistoren 2 und 3 ist das Zinkoxid-Material des Substratkörpers 5 mit Varistoreigenschaft versehen. Entsprechend einem der Erfindung gewählten Herstellungsverfahren ist dort das zuvor elektrisch isolierende bis hochomige Zinkoxid-Material durch Dotierung in Varistor-Material umgewandelt.

Die beiden mit 8 bezeichneten, in der Fig. 1 gestrichelt eingetragenen Linien sind die Begrenzungen für eine auf der Rückseite des Substratkörpers 5 angebrachte Metallisierung, die in erster Linie als Gegenelektrode für die Varistoren 2 und 3 verwendet wird und außerdem auch als rückwärtige elektrische Abschirmung der integrierten Schaltung 4 dient. Auf denjenigen Anteilen der Rückseite des Substratkörpers 5, die auf der Vorderseite des Substratkörpers 5 angebrachten Leiterbahnen gegenüberliegen, ist vorzugsweise keine Metallisierung (der Rückseite) vorgesehen, um unnötige zusätzliche Kapazitäten zu vermeiden.

Sollten solche Kapazitäten jedoch nicht stören, können—söfern z.B. elektrische Abschirmung gewünscht wird—weitere Anteile der Rückseite des Substratkörpers 5 metallisiert sein. Diese rückseitige Metallisierung des Substratkörpers im Bereich zwischen den Linien 8 wird im Regelfall an Masse angeschlossen, wozu die Anschlußkontakte 9 vorhanden sind. Mit 10 und 11 sind die Anschlußkontakte des Substratkörpers bezeichnet, die für den Anschluß der elektrischen Versorungsspannung vorgesehen sind. Diese Kontakte 10 und 11 sind mit den auf der Vorderseite des Substratkörpers 5 aufgebrachten Elektroden 12 bzw. 13 elektrisch verbunden, die zum besseren Erkennen durch Schraffur hervorgehoben sind. Diese Elektroden 12 bzw. 13 sind deckungsgleich mit den voranstehend erwähnten Varistoren 2 und 3, soweit diesen Elektroden 12, 13 auf der Rückseite des Substratkörpers 5 eine Gegenelektrode 8 gegenüberliegt.

Mit 14 sind die elektrischen Drahtverbindungen zwischen dem jeweiligen Varistor und der Schaltung 4 bezeichnet. Diese Verbindungen sind extrem kurz, so daß deren Eigeninduktivität minimal ist.

Fig. 2 zeigt ein elektrisches Schaltbild zum Aufbau der Fig. 1. Die Schaltungssymbole der Fig. 2 haben dieselben Bezugszeichen, die das gleiche elektronische Bauteil in der Anordnung der Fig. 1 hat. Aus dem Schaltbild der Fig. 2 ist zu erkennen, wie die die Schaltung 4 vorÜberspannung schützenden Varistoren 2 und 3 elektrisch—in an sich bekannter Weise—in der Gesamtschaltung angeschlossen sind.

Ein Vorteil einer wie dargestellten erfindungsgemäßen Schaltungsanordnung ist, daß die aus dem Stand der Technik bekannten hohen Eigeninduktivitäten ER Anschlußleitungen der Varistoren hier praktisch vollständig wegfallen. so daß die Varistoren die integrierte Schaltung auch vor sehr steilen Überspannungsstößen schützen können.

Fig. 3 zeigt lediglich eine Übersichtsdarstellung zu einer erfindungsgemäßen Ausführungsform mit einer Hybridschaltung mit mehreren integrierten Schaltungen 4, 4', 4'', und weiteren Einzelbauelemeten 34. Zugehörige Varistoren, die integrierte Bestandteile des Substratkörpers 5' sind, sind mit 2', 2'' bzw. 3', 3'' bezeichnet. Obige Einzelbauelemente können z.B. Vielschicht-Kondensatoren, Widerstände und dergleichen sein.

Der bei der Erfindung verwendete elektrisch isolierende Substratkörper besteht aus Zinkoxid, das mit beispielsweise 1 bis 5 Gew.% Manganoxid oder Lithiumoxid zu einem Material mit sehr hohem speizifischen elektrischen Widerstand dotiert ist.

Fig. 4 zeigt ein Flußdiagramm zum Herstellungsverfahren. Es wird pulverförmiges Zinkoxid mit dem vorgesehenen Manganoxid in wässrigem Schlicker gemischt und gemahlen (41), entwässert und mit einem Plastifizierungsmittel, wie z.B. Polyviol, versetzt. Er werden dann Platten mit Dickenabmessungen zwischen 0,2 und 1 mm in der gewünschten Größe hergestellt, z.B. durch Formpressen oder Bandzieh-Verfahren (42). Die getrockneten Rohplatten werden schließlich bei Temperaturen zwischen 1050°C und 1200°C in Luft gesintert (43). Hierbei entsteht elektrisch isolierende Zinkoxid-Keramik.

Die hergestellten gesinterten Platten werden nunmehr beispielsweise im Siebdruck-Verfahren mit einem pastösen Gemisch aus vorzugsweise mehreren der Dotierungsoxide und einem organischen Bindemittel in den Bereichen bedruckt (44), in denen später die Varistoren 2, 3 vorliegen sollen. Als Oxide können bekanntermaßen für Varistor-Keramik verwendete Wismut-, Kobalt-, Antimon-, Chrom-, Titan-, Bor- und Praseodymoxide verwendet werden. Nachdem das aufgedruckte pastöse Gemisch getrocknet ist, erfolgt zur Herstellung der Erfindungsgemäß im vorgesehenen Substratkörper 5, 5' enthaltenen integrierten Varistoren 2 und/oder 3, (2' ..., 3' ...) ein Temperprozeß (45) in oxidierender Atmosphäre bei Temperaturen zwischen 750 und 1380°C, 0,1 bis 2 Stunden lang. Die in das Keramikmaterial des Substratkörpers 5 eindiffundierenden Oxide erzeugen elektrische Leitfähigkeit in dem zuvor isolierenden Kernvolumen und elektrisch isolierenden Kornrandschichten, wie sie prinzipiell bei einem bekannten Zinkoxid-Varistor vorliegen.

Die wie zur Fig. 1 ausführlich beschriebenen vorgesehenen Elektroden-Metallisierungen 12, 13 der Varistoren 2, 3 werden z.B. durch Aufdampfen, Aufsputtern oder Siebdrucken mit Einbrennen entsprechender Metalle hergestellt (46). Dabei werden auch gleichzeitig die Anschluß-Leiterbahnen 6 und andere Kontakte und Leiterbahnen 9, 10, 11 hergestellt. Ein Substratkörper 5 ist damit fertig hergestellt zur Bestückung mit den entsprechenden integrierten Schaltungen und mit gegebenenfalls zusätzlich vorgesehenen elektronischen Bauelementen.

Fig. 5 zeigt eine weitere Ausführungsform für einen erfindungsgemäß in einem Substratkörper realisierbaren Varistor 52. Elektrode 53 und Gegenelektrode 58 befinden sich hier auf ein und derselben Oberfläche des im Ausschnitt dargestellten Substratkörpers 55, der vorzugsweise nur zu einem Anteil 56 seiner Dicke Varistoreigenschaften aufweist.

## Patentansprüche

1. Kombinierte Schaltungsanordnung (1) mit mehreren elektronischen Bauelementen (2, 3, 4), bei der

a) mindestens ein Bauelement (4) auf einem Substratkörper (5) aus Zinkoxid-Keramik angeordnet und

b) mit mindestens einem weiteren im Substratkörper (5) befindlichen Bauelement (2, 3) elektrisch leitend verbunden ist, dadurch gekennzeichnet,

c) da mindestens ein Teilbereich (2, 3) des Substratkörpers (5) mit Varistoreigenschaften ausgebildet und mit zwei, auf einer oder beiden Oberflächen des Teilbereiches angeordneten Elektroden (8; 12, 13) versehen ist und jeweils das weitere Bauelement bildet und

d) daß die übrigen Bereiche des Substratkörpers (5) elektrisch wenigstens nahezu isolierend ausgeführt sind.

2. Kombinierte Schaltungsanordnung nach Anspruch 1, gekennzeichnet dadurch, daß g) sich auf dem Substratkörper (5') wenigstens eine integrierter Halbleiterschaltung (4, 4', 4'') und wenigstens ein weiteres hybridisiertes elektronisches Bauelement (34) befindet (Fig. 3).

3. Verfahren zur Herstellung des Substratkörpers (5) für eine kombinierte Schaltungsanordnung nach einem der Ansprüche 1 bis 2, gekennzeichnet dadurch, daß zunächst (41—43) ein plattenförmiger keramischer Körper (5) aus Zinkoxid, dem ein die Keramik elektrisch isolierend machender Dotierungsstoff zugegeben worden ist, hergestellt wird und daß in weiteren Verfahrensschritten für Varistoren (2, 3) vorgesehene Flächenanteile des Körpers (5) mit einem pastösen Gemisch aus Dotierungsstoffen belegt werden (44) und anschließend in einem Temperprozeß (45) bei Temperaturen zwischen 750 und 1380°C und 0,1 bis 2 Stunden die Varistoreigenschaft im Keramikmaterial dieses Körpers (5) unterhalb der belegten Flächenanteile hergestellt wird.

## Revendications

1. Montage combiné (1) avec plusieurs composants électroniques (2, 3, 4) dans lequel

a) au moins un composant (4) est disposé sur un corps de substrat (5) en une céramique à oxyde de zinc, et

b) est relié à conduction électrique avec au moins un second composant (2, 3) situé dans le corps de substrat (5) caractérisé par le fait

c) qu'au moins une zone partielle (2, 3) du corps de substrat (5) est formée de manière à présenter des propriétés d'un varistor, et est pourvue de deux électrodes (8; 12, 13) disposées sur une ou sur les deux surfaces de la zone partielle, en constituant ledit second composant et

d) que les zones subsistantes du corps de substrat (5) sont réalisées de manière à être pour le moins électriquement isolantes.

2. Montage combiné selon la revendication 1, caractérisé par le fait que g) se situent sur le corps de substrate (5') au moins un circuit à semiconducteurs intégré (4, 4', 4'') et au moins un composant électronique supplémentaire hybridé (34).

3. Procédé pour la fabrication du corps de substrat (5) pour un montage combiné selon l'une des revendications 1 à 2, caractérisé par le fait que l'on prépare d'abord (41—43) un corps céramique en forme de plaque (5) en oxyde de zinc auquel on a ajouté une substance de dopage qui concère à la céramique une propriété d'isolant électrique et qu'au cours d'autres phases opératives on revêt d'un mélange pâteux de substances de dopage, des parties de la surface du corps (5) qui sont prévues pour des varistors (2, 3) et qu'on établit ensuite, au cours d'un processus de recuit (45) à des températures se situant entre 750° et 1380° et pendant 0, 1 à 2 heures, la propriété de varistor dans le matériau céramique de ce corps (5), endessous des parties de surfaces enduites.

## Claims

1. Combined circuit arrangement (1) having a plurality of electronic components (2, 3, 4) in which

a) at least one component (4) is arranged on a substrate body (5) consisting of zinc oxide ceramic and

b) is electrically conductively connected to at least one further component (2, 3) located in the substrate body (5), characterized

c) in that at least one sub-region (2, 3) of the substrate body (5) is constructed with varistor properties and is provided with two electrodes (8; 12, 13) arranged on one or both surfaces of the sub-region and forms in each case the further component and

d) in that the other regions of the substrate body (5) are designed to be at least almost electrically insulating.

2. Combined circuit arrangement according to Claim 1, characterized in that g) at least one integrated semiconductor circuit (4, 4', 4'') and at least one further hybridized electronic component (34) is located on the substrate body (5') (Fig. 3).

3. Method of manufacmring the substrate body (5) for a combined circuit arrangement according to one of Claims 1 to 2, characterized in that firstly (41—43) a plate-shaped ceramic body (5) consisting of zinc oxide, to which a doping material rendering the ceramic electrically insulating has been added, is manufactured, and in that, in further process steps, surface portions of the body (5) provided for varistors (2, 3) are coated (44) with a paste-like mixture of doping materials and subsequently in a temperature process (45) at temperatures between 750 and 1380°C and for 0.1 to 2 hours, the varistor property in the ceramic material of this body (5) is manufactured below the coated surface portions.

FIG 1

FIG 2

FIG 3

F I G 4

| Ausgangsmaterial mischen, mahlen, entwässern | 41 |
|---|---|
| Formgabe | 42 |
| Sintern | 43 |
| Aufbringen der Dotierungsstoffe | 44 |
| Tempern | 45 |
| Kontaktierung des fertigen Substrat- körpers | 46 |

F I G 5